# EUROPEAN PATENT SPECIFICATION

(11) **EP 3 510 370 B1**
(45) Date of publication and mention of the grant of the patent: **27.10.2021**
(21) Application number: 17767894.3
(22) Date of filing: 07.09.2017
(51) Int. Cl.: G01K 7/02

(54) **THERMOCOUPLE WITH A LIMB CONSISTING OF DOPED PLATINUM**
THERMOELEMENT MIT EINEM AUS DOTIERTEM PLATINUM BESTEHENDEN SCHENKEL
THERMOCOUPLE AVEC UN CONDUCTEUR SE COMPOSANT DE PLATINE DOPÉ

(30) Priority: 08.09.2016 GB 201615272
(43) Date of publication of application: 17.07.2019
(73) Proprietor: Johnson Matthey Public Limited Company, London EC4A 4AB (GB)
(72) Inventor: WILKINSON, Roger, Royston, Hertfordshire SG8 5HE (GB)
(74) Representative: Lorkin, Thomas James Anthony
(86) International application number: PCT/GB2017/052609
(87) International publication number: WO 2018/046921

(56) References cited:
- EP-A1- 1 544 314
- EP-A1- 2 778 639
- CN-A- 103 952 585
- US-A- 3 696 502
- BAOYUAN WU ET AL: "Platinum:Platinum-Rhodium Thermocouple Wire IMPROVED THERMAL STABILITY ON YTTRlUM ADDITION TO PLATINUM", PLATINUM METALS REVIEWS, vol. 41, no. 2, 1 April 1997 (1997-04-01), pages 81-85, XP055421842,

## Description

### Field of the Invention

The present invention concerns Pt vs. RhPt thermocouples, in particular the modification of the electrical properties of a Pt vs. RhPt thermocouple while in service.

### Background

A thermocouple is used to measure the temperature of an environment, often over long periods of time and at constant temperature. Pure platinum (Pt) is used as the negative limb of Type R and Type S thermocouples. Very pure platinum is weak at high temperatures and is often the cause of thermocouple open circuit failure. While introducing metallic alloying elements into the Pt limb may decrease the likelihood of Pt limb failure, the metallic alloying elements can adversely affect the electrical properties of the thermocouple.

One source of error in thermocouple measurement is drift, where the acquired voltage changes over time from the expected value despite the temperature remaining substantially constant. Drift is generally caused by contamination of the Pt limb. Contamination can be built in, acquired in service or originate from the thermocouple's rhodium-platinum alloy (RhPt alloy) limb.

Rhodium drift (also known as "migration") is the transfer of rhodium (Rh) from the RhPT alloy limb to the Pt limb. The metal transfer is possible because Rh oxide is volatile above 1200 °C and the gas diffuses or convects to cooler areas where it condenses. Rhodium oxide is not very stable and, once it dissociates, the Rh metal contaminates the Pt limb. Rh oxide can often be seen as a black layer covering the alloy limb.

EP2778639A (to Tanaka Kikinzoku Kogyo K.K.) describes a Pt vs. Pt-Rh based thermocouple wherein the Pt wire contains a zirconium (Zr) oxide in an amount of 0.02 to 0.5 mass% in terms of Zr dispersed in the Pt wire. The Pt wire is prepared by introducing a dispersion of electrically neutral zirconia particles into Pt powder by wet ball milling in a zirconia container, using zirconia balls. The wire, once made, is ultimately treated for 3 hours at 1700 °C to ensure full oxidation of the zirconia and restore the electrical properties of the wire. EP2778639A neither discloses nor suggests how to minimise drift over the lifetime of a thermocouple whilst in service.

US3696502 (to Johnson Matthey & Company Limited) described a method for making dispersion strengthened metals or alloys.

### Description of the Invention

The present invention seeks to overcome the disadvantages associated with prior art thermocouples. The invention provides a method for achieving substantially consistent and reliable readings from a Pt vs. RhPt thermocouple over its service life. In certain embodiments, the invention provides a method for prolonging the service life of a Pt vs. RhPt thermocouple.

In one aspect, the present invention provides a thermocouple as defined in claim 1. In another aspect, the present invention provides a method as defined in claim 7. Particular embodiments of the present invention are defined in the dependent claims

The Pt limb of the thermocouple is doped platinum. "Doped" refers to the intentional introduction of ≤ 0.01 wt% zirconium. "Doping" and "dopant" are construed accordingly.

The platinum to which the dopant is added is ≥ 99.997 wt% pure, such as ≥ 99.999 wt% pure.

The doped platinum comprises zirconium. Without wishing to be bound by theory, it is believed that the inclusion of zirconium actively counters the effect of rhodium drift through its oxidation to zirconium oxide. Rhodium drift causes the negative Pt limb to become more positive in use but, as a result of the oxidation of zirconium, the Pt limb of the thermocouple does not become as positive as quickly. The thermocouple of the invention, therefore, experiences drift but it is opposite to that caused by rhodium drift, thus counteracting the effects of the undesirable rhodium drift. This is in contrast with prior art thermocouples, such as those described by Tanaka in EP2778639A as Tanaka purport that the thermocouple in that instance does not experience drift for practical purposes.

The doped platinum comprises ≤ 0.01 wt% of zirconium, such as 0.001 to 0.01 wt% (e.g. 0.0025 to 0.0075 wt%). The doped platinum may comprise ≥ 0.0015 wt%, ≥ 0.0025 wt%, or ≥ 0.005 wt% zirconium. The doped platinum may comprise ≤ 0.009 wt%, ≤ 0.008 wt%, ≤ 0.007 wt%, ≤ 0.006 wt%, or ≤ 0.005 wt% zirconium.

In one embodiment, the doped platinum comprises 0.0025 to 0.0075 wt% of zirconium. The doped platinum may comprise ≥ 0.0025 wt%, ≥ 0.003 wt%, ≥ 0.0035 wt%, ≥ 0.004 wt% or ≥ 0.0045 wt% of zirconium. The doped platinum may comprise ≤ 0.0075 wt%, ≤ 0.007 wt%, ≤ 0.0065 wt%, ≤ 0.006 wt%, ≤ 0.0055 wt% of zirconium. In one embodiment, the doped platinum comprises 0.005 wt% of zirconium.

The thermocouple is used in an oxidising atmosphere, for example, an atmosphere comprising oxygen, NOx (i.e. oxides of nitrogen) or a combination thereof. In one preferred embodiment, the atmosphere comprises oxygen (for example, air).

The doped platinum may further comprise:
(c) an effective amount of zirconium oxide.

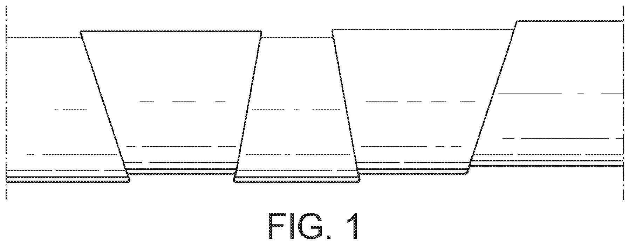

Failure of a thermocouple can be due to grain growth where single grains grow at the expense of others and may eventually occupy the entire diameter of the wire leading to a "bamboo structure" (see Figure 1). The bamboo structure can make the wire weaker as the stress to cause slip in a single grain is lower than across multiple grains. In addition, the boundaries between grains can be a source of weakness both from contamination, slip and from diffusional or creep processes at high temperature which cause voids to form and eventually separation or fracture of the wire.

An "effective amount" of zirconium oxide means the amount of zirconium oxide needed to reduce grain growth in the Pt limb.

Zirconium oxide may be added to the platinum during manufacture of the doped platinum. Alternatively, zirconium oxide may be formed in situ by partially oxidising the dopant (zirconium) during the manufacture of the doped platinum. Regardless of the method by which the zirconium oxide is incorporated, the zirconium oxide is present in addition to any dopant which is converted in use of the thermocouple to the corresponding dopant oxide.

The doped platinum may comprise 0.001 to 0.01 wt% (e.g. 0.0025 to 0.0075 wt%) of zirconium oxide. The doped platinum may comprise ≥ 0.0015 wt%, ≥ 0.0025 wt%, or ≥ 0.005 wt% of zirconium oxide. The doped platinum may comprise ≤ 0.01 wt% ≤ 0.009 wt%, ≤ 0.008 wt%, ≤ 0.007 wt%, ≤ 0.006 wt%, or ≤ 0.005 wt% of zirconium oxide.

In one embodiment, the doped platinum may comprise 0.0025 to 0.0075 wt% of zirconium oxide. The doped platinum may comprise ≥ 0.0025 wt%, ≥ 0.003 wt%, ≥ 0.0035 wt%, ≥ 0.004 wt% or ≥ 0.0045 wt% of zirconium oxide. The doped platinum may comprise ≤ 0.0075 wt%, ≤ 0.007 wt%, ≤ 0.0065 wt%, ≤ 0.006 wt%, ≤ 0.0055 wt% of zirconium oxide. In one embodiment, the doped platinum comprises 0.005 wt% of zirconium oxide.

The invention will now be described by way of the following non-limiting Examples and with reference to the following Figure in which:
Figure 1 illustrates a bamboo structure resulting from grain growth in a 0.5 mm diameter pure Pt wire from a failed Pt limb.

### Example

### Example 1

### Preparation of the Pt limb

The example is produced by partially oxidizing an alloy of platinum and zirconium to give both metallic zirconium and oxidized zirconium in the platinum.

The alloy contains approximately 100 ppm by weight of zirconium prior to partial oxidation. 0.6 g of zirconium is added to 6.5 kg of high purity platinum (99.997 wt% pure); 92 ppm by weight of zirconium was added.

The platinum used is of thermocouple quality. It is analysed before alloying with zirconium and is found to contain 33 ppm by weight of impurities by direct measurement). The emf output of the platinum before alloying with zirconium is measured in comparison with NIST SRM 1967a Pt reference material (0µV) and is found to be between 8 µV and 10 µV at approximately 1064 °C and between 15 µV and 18 µV at approximately 1554 °C.

The alloy is melted under a reduced pressure protective atmosphere of inert gas to prevent oxidation of the zirconium. The resulting ingot is hot forged, cold rolled and drawn to form wire. The wire is flame sprayed to form a slab of partially bonded flakes with porosity between the flakes; this provides a continuous but fragile structure. Some zirconium oxidation occurs during the spraying process.

The slab is heated in air to promote further but not total oxidation. The slab is compacted to a fully dense bar by hot forging. The bar is cold rolled and drawn to a 0.5 mm diameter wire.

After annealing using electrical resistive heating to heat the wire to 1100 °C for 10 minutes the emf output of the wire is measured in comparison with NIST SRM 1967a and found to be 32 µV at approximately 1064 °C and between 53 µV and 54 µV at approximately 1554 °C.

### Example 2

### Positive drift

A sample of the wire prepared according to Example 1 is heated in air in an electric furnace at 1200 °C for 140 hours to simulate service conditions. The wire is again measured in comparison with NIST SRM 1967a and the output is 27 µV at approximately 1064 °C and 49 µV at approximately 1554 °C.

A reduction in output of the Pt limb in a thermocouple comprising Pt and 10%RhPt (Type S) or Pt and 13%RhPt (Type R) increases the indicated temperature of the thermocouple. The measured reduction in the emf of the Pt limb equates to a 0.4 °C increase in the indicated temperature of a Type R or Type S thermocouple at both the test temperatures.

The output of a sample of the wire prepared according to Example 1 is measured before and after heating at 1200°C in air for 140 hours:

| Temperature | Before | After | Change | |
|---|---|---|---|---|
| | (µV) | (µV) | (µV) | (°C) |
| Approximately 1064 °C | 32 | 27 | 5 | 0.4 |
| Approximately 1554 °C | 54 | 49 | 5 | 0.4 |

Without wishing to be bound by theory, the measured reduction in the Pt limb output relative to pure Pt reference material is significant because the Pt limb of a thermocouple normally becomes increasingly contaminated in use with metallic impurities both from the local environment and from the RhPt alloy thermocouple limb (referred to as Rh migration or Rh drift). The observed effect acts to counter the normal drift.

The reduction in output has been caused by the further oxidation of metallic zirconium in the wire. Increasing the level of metallic contamination in the Pt limb always reduces the temperature indicated by the thermocouple. In contrast adding oxide inclusions to Pt does not change the emf output by the same amount and the effect of adding ZrO₂ may be negligible. Converting metallic zirconium to oxidized zirconium in use therefore acts to reduce the emf output of the Pt and compensate for other acquired contamination.

Compensating for normal downward drift in the thermocouple indicated temperature is important because otherwise the drift would be greater and the thermocouple would have a shorter service life.

## Claims

1. A Pt vs. RhPt thermocouple, wherein the thermocouple comprises a Pt limb and a RhPt limb, **characterised in that** the Pt limb of the thermocouple is doped platinum comprising:
(a) platinum; and
(b) ≤ 0.01 wt% of zirconium;
wherein the platinum to which the dopant is added is ≥ 99.997 wt% pure.

2. A thermocouple according to claim 1, wherein the platinum to which the dopant is added is ≥ 99.999 wt% pure.

3. A thermocouple according to any one of the preceding claims, wherein the doped platinum comprises 0.001 to 0.01 wt% of zirconium.

4. A thermocouple according to any one of the preceding claims, wherein the Pt limb of the thermocouple comprises 0.0025 to 0.0075 wt% of zirconium.

5. A thermocouple according to any one of the preceding claims, wherein the doped platinum further comprises:
(c) ≤ 0.01 wt% of zirconium oxide.

6. A thermocouple according to claim 5, wherein the doped platinum comprises about 0.001 to about 0.01 wt% of zirconium oxide.

7. A method for reducing the drift of a thermocouple while the thermocouple is in use in an oxidizing environment, wherein the thermocouple comprises a Pt limb and a RhPt limb, **characterised in that** the Pt limb of the thermocouple is doped platinum comprising:
(a) platinum; and
(b) ≤ 0.01 wt% of zirconium;
wherein the platinum to which the dopant is added is ≥ 99.997 wt% pure.

8. A method according to claim 7, wherein the platinum to which the dopant is added is ≥ 99.999 wt% pure.

9. A method according to claim 7 or claim 8, wherein the doped platinum comprises 0.001 to 0.01 wt% of zirconium.

10. A method according to any one of claims 7 to 9, wherein the Pt limb of the thermocouple comprises 0.0025 to 0.0075 wt% of zirconium.

11. A method according to any one of claims 7 to 10, wherein the doped platinum further comprises:
(c) ≤ 0.01 wt% of zirconium oxide.

12. A method according to claim 11, wherein the Pt limb of the thermocouple comprises 0.001 to 0.01 wt% of zirconium oxide.

13. A method according to claim any one of claims 7 to 12, wherein the oxidising atmosphere comprises oxygen, NOx or a combination thereof.

## Patentansprüche

1. Pt/RhPt-Thermoelement, wobei das Thermoelement einen Pt-Schenkel und einen RhPt-Schenkel aufweist, **dadurch gekennzeichnet, dass** der Pt-Schenkel des Thermoelements dotiertes Platin ist, das Folgendes enthält:
(a) Platin; und
(b) < 0,01 Gew.-% Zirkonium;
wobei das Platin, dem das Dotiermittel zugesetzt ist, ≥ 99,997 Gew.-% rein ist.

2. Thermoelement nach Anspruch 1, wobei das Platin, dem das Dotiermittel zugesetzt ist, ≥ 99,999 Gew.-% rein ist.

3. Thermoelement nach einem der vorhergehenden Ansprüche, wobei das dotierte Platin 0,001 bis 0,01 Gew.-% Zirkonium enthält.

4. Thermoelement nach einem der vorhergehenden Ansprüche, wobei der Pt-Schenkel des Thermoelements 0,0025 bis 0,0075 Gew.-% Zirkonium enthält.

5. Thermoelement nach einem der vorhergehenden Ansprüche, wobei das dotierte Platin ferner enthält:
(c) ≤ 0,01 Gew.-% Zirkoniumoxid.

6. Thermoelement nach Anspruch 5, wobei das dotierte Platin etwa 0,001 bis etwa 0,01 Gew.-% Zirkoniumoxid enthält.

7. Verfahren zur Verringerung der Drift eines Thermoelements, während das Thermoelement in einer oxidierenden Umgebung verwendet wird, wobei das Thermoelement einen Pt-Schenkel und einen RhPt-Schenkel aufweist, **dadurch gekennzeichnet, dass** der Pt-Schenkel des Thermoelements dotiertes Platin ist, das Folgendes enthält:
(a) Platin; und
(b) ≤ 0,01 Gew.-% Zirkonium;
wobei das Platin, dem der Dotierstoff zugesetzt ist, ≥ 99,997 Gew.-% rein ist.

8. Verfahren nach Anspruch 7, wobei das Platin, dem das Dotiermittel zugesetzt ist, ≥ 99,999 Gew.-% rein ist.

9. Verfahren nach Anspruch 7 oder Anspruch 8, wobei das dotierte Platin 0,001 bis 0,01 Gew.-% Zirkonium enthält.

10. Verfahren nach einem der Ansprüche 7 bis 9, wobei der Pt-Schenkel des Thermoelements 0,0025 bis 0,0075 Gew.-% Zirkonium enthält.

11. Verfahren nach einem der Ansprüche 7 bis 10, wobei das dotierte Platin ferner enthält:
(c) ≤ 0,01 Gew.-% Zirkoniumoxid.

12. Verfahren nach Anspruch 11, wobei der Pt-Schenkel des Thermoelements 0,001 bis 0,01 Gew.-% Zirkoniumoxid enthält.

13. Verfahren nach einem der Ansprüche 7 bis 12, wobei die oxidierende Atmosphäre Sauerstoff, NOx oder eine Kombination davon enthält.

## Revendications

1. Thermocouple Pt vs RhPt, dans lequel le thermocouple comprend une branche de Pt et une branche de RhPt, **caractérisé en ce que** le limbe de Pt du thermocouple est du platine dopé comprenant :
(a) du platine ; et
(b) ≤ 0,01% en poids de zirconium ;
dans lequel le platine auquel le dopant est ajouté est pur à ≥ 99,997% en poids.

2. Thermocouple selon la revendication 1, dans lequel le platine auquel le dopant est ajouté est pur à ≥ 99,999% en poids.

3. Thermocouple selon l'une quelconque des revendications précédentes, dans lequel le platine dopé comprend de 0,001 à 0,01% en poids de zirconium.

4. Thermocouple selon l'une quelconque des revendications précédentes, dans lequel la branche de Pt du thermocouple comprend de 0,0025 à 0,0075% en poids de zirconium.

5. Thermocouple selon l'une quelconque des revendications précédentes, dans lequel le platine dopé comprend en outre :
(c) ≤ 0,01% en poids d'oxyde de zirconium.

6. Thermocouple selon la revendication 5, dans lequel le platine dopé comprend d'environ 0,001 à environ 0,01% en poids d'oxyde de zirconium.

7. Procédé de réduction de la dérive d'un thermocouple pendant l'utilisation du thermocouple dans un environnement oxydatif, dans lequel le thermocouple comprend une branche de Pt et une branche de RhPt, **caractérisé en ce que** la branche de Pt du thermocouple est du platine dopé comprenant :
(a) du platine ; et
(b) ≤ 0,01% en poids de zirconium ;
dans lequel le platine auquel le dopant est ajouté est pur à ≥ 99,997% en poids.

8. Procédé selon la revendication 7, dans lequel le platine auquel le dopant est ajouté est pur à ≥ 99,999% en poids.

9. Procédé selon la revendication 7 ou la revendication 8, dans lequel le platine dopé comprend de 0,001 à 0,01% en poids de zirconium.

10. Procédé selon l'une quelconque des revendications 7 à 9, dans lequel la branche de Pt du thermocouple comprend de 0,0025 à 0,0075% en poids de zirconium.

11. Procédé selon l'une quelconque des revendications 7 à 10, dans lequel le platine dopé comprend en outre
(c) ≤ 0,01% en poids d'oxyde de zirconium.

12. Procédé selon la revendication 11, dans lequel la branche de Pt du thermocouple comprend de 0,001 à 0,01% en poids d'oxyde de zirconium.

13. Procédé selon l'une quelconque des revendications 7 à 12, dans lequel l'atmosphère oxydante comprend de l'oxygène, du NOx ou une combinaison de ceux-ci.
